# EUROPEAN PATENT APPLICATION

(11) **EP 1 251 543 A1**
(43) Date of publication of application: **23.10.2002**
(21) Application number: 02252741.0
(22) Date of filing: 18.04.2002
(51) Int. Cl.: H01J 21/10

(54) **Vacuum power switches**

(30) Priority: 18.04.2001 GB 0109546
(71) Applicant: VA TECH Transmission & Distribution GmbH & Co. KEG, 1141 Wien (AT)
(72) Inventor: Amaratunga, Gehan Anil Joseph, Cambridge CB2 2RW (GB); Chhowalla, Manish, Cambridge CB1 2DG (GB); Rupesinghe, Nalin, Cambridge CB3 0DS (GB)
(74) Representative: Smart, Peter John

(57) **Abstract**

A vacuum power switch comprising an anode (16), a cathode (12) having an array (20) of aligned carbon nanotubes extending towards the anode (16), and a current switching grid (14) between the cathode (12) and the anode (16). The array (20) of aligned carbon nanotubes may be produced by chemical vapour deposition from a carbon containing gas on to a substrate bearing islands of catalytic metal.

## Description

The present invention relates to vacuum power switches comprising carbon nanotubes as field emitters on the cathode and optionally on the anode.

Graphite is formed from graphene sheets of sp2 hybridised carbon atoms bound in a hexagonal lattice by C-C bonds. The weak bonding between the delocalised electrons of the overlying graphene sheets gives graphite its well known mechanical and electrical properties. Carbon nanotubes comprise sheets of graphene curved round so that the dangling bonds at their edges join to form a tube. Single walled nanotubes (SWNTs) have their ends closed by hemispherical shells including pentagons of carbon atoms, as in fullerenes. Multi-walled nanotubes (MWNTS) comprise layers of single graphene sheets and may be open ended with the dangling bonds at the tube ends in each sheet forming interlayer connections.

Carbon nanotubes are attracting great interest for their remarkable properties such as ballistic electron transport and large elastic moduli. The high surface area and chemical inertness of nanotubes grown directly onto desired substrates makes them attractive for demanding applications such as electrochemistry, electrodes for fuel cells and supercapacitors. Their field emission characteristics have suggested their use in micro electronic devices and in cold cathode displays. (V I Merkulov, D H Lowndes, L R Baylor, et al)

High quality single walled carbon nanotubes and multi-walled carbon nanotubes can be obtained using high pressure arcs, laser ablation and high pressure chemical vapour deposition (CVD). Many applications demand nanotubes with well defined diameters and lengths. MWNTs can be deposited using plasma enhanced chemical vapour deposition (PECVD) methods onto substrates coated with a suitable transition metal catalyst. The essential parameters involved in the growth of aligned carbon nanotubes (ACNTs) are the feed gas, the nature of the catalyst and the substrate temperature. Free standing aligned nanotubes were first grown using a hot filament plasma enhanced chemical vapour deposition method (Ren et al). Subsequently, various plasma methods have been used (Bower et al, V I Merkulov, D H Lowndes, Y Y Wei et al, Andrews et al, Cui et al, and Hoshi et al.

There is presently great interest in ACNTs for field emission and vacuum microelectronic devices because carbon nanotubes are amongst the best field emitters presently available (de Heer et al, Bonard et al, Kim et al, Zhu et al and Collins et al). Their excellent field emission characteristics are attributed to the high aspect ratios, resulting in a large field enhancement factor. Carbon nanotubes are also mechanically and chemically robust and can emit large current densities at low electric fields. The ability to grow carbon nanotubes on conducting substrates over a large area is essential for uniform emission required for vacuum microelectronic devices.

Whilst the use of carbon nanotubes in low current microelectronic devices and in display technology has been considered, we have identified a further valuable role for aligned carbon nanotubes. In the switching of high currents at large voltages, use is presently made of solid state switches in which a semiconductor is switched from an insulating to a conducting state to make a connection. The high voltage capabilities of these devices is limited by the thickness of semiconductor needed to produce a sufficiently high resistance in the off state and the consequent resistance to current flow offered in the on state.

In a vacuum switch, electrons are emitted into vacuum from a cathode either thermally or from a cold cathode in response to a grid voltage and are collected at an anode. As the vacuum between the cathode and anode has no electrical resistance, the problem of high on state resistance for high voltage switching may be overcome. Micro-engineered vacuum cold cathode switches have been developed in which the cathode is provided with an array of molybdenum spikes, which may be carbon coated. The Mo tips are produced by film deposition and etching. The maximum current that can be carried by such devices at high voltages is however only in the region of 1 amp and higher currents require parallel arrays of such switches.

The present invention now provides a vacuum power switch comprising a cathode, an anode and a current switching grid between the cathode and the anode, wherein the cathode comprises an array of aligned carbon nanotubes extending toward the anode. Preferably, the switch is so constructed as to be capable of switching a current of at least 5 amps at a voltage of 1 kV or more, more preferably a current of at least 50 amps at a voltage of 1 kV or more and most preferably a current of at least 500 amps at a voltage of 1 kV or more.

Preferably, such currents can be switched at voltages of up to 10 kV, more preferably 20 kV.

Preferably, the nanotubes in said array have an average mid-length diameter of 20 nm or more, more preferably 80 nm or more.

The nanotubes in said array preferably have an average mid-length diameter of from 5 to 500 nm, more preferably 5 to 100 nm, highly preferably 80 to 100 nm, but the diameter may for instance be up to 500 nm.

Preferably, the nanotubes in said array have an average spacing from the nearest neighbouring nanotubes such as to provide a density on the surface of from 1 x 10⁶ to 1 x 10⁹ tubes per cm², more preferably 1 to 10 x 10⁸, e.g. 4 to 6 x 10⁸, tubes per cm². Alternatively, this density may be from 1 x 10⁴ to 1 x 10⁹ tubes per cm², more preferably 5 x 10⁴ to 5 x 10⁵ per cm².

The nanotubes are preferably produced by plasma enhanced chemical vapour deposition from a carbon containing gas onto a substrate bearing islands of catalytic metal.

An accessory or etching gas such as ammonia or hydrogen is mixed with the carbonaceous gas and optionally the substrate and the catalytic metal may be exposed to the accessory or etching gas prior to introducing the carbonaceous gas. The function of the accessory gas appears to be to etch away amorphous carbon formed when the carbonaceous gas contacts the metal catalyst. The more stable graphene sheets forming the nanotubes are more resistant to the accessory gas' etching action. The ratio of carbonaceous gas to accessory gas may be varied over a wide range. In the absence of the accessory gas, it is found that nanotube formation does not occur and the metal catalyst becomes covered with amorphous carbon. A preferred content of the carbonaceous gas in the mixture is from 5 to 30%, more preferably 15 to 30%. Above 30% in the case of a mixture of C₂H₂/NH₃, the nanotubes become obelisk like and at still higher acetylene contents (e.g. 75%) become short and pyrimidal. Such 'nanotubes' may still be used in accordance with the invention however.

Said islands preferably have an average diameter of from 5 to 500nm, more preferably from 5 to 100 nm, highly preferably from 80 to 100 nm.

Said islands are preferably formed by annealing a metal film deposited on a substrate so as to cause the film to break up to form said islands. The substrate may be any metal which is stable at the high temperatures employed but is preferably a highly conductive graphite. As known in the art, the thickness of the metal film governs the size of the islands formed on annealing the film and this in turn governs the tube diameter.

The thickness of said film prior to annealing is preferably at least 1 nm, e.g. between 1 and 50 nm, more preferably at least 2 nm, e.g. from 2 to 10 nm, e.g. about 4 nm.

Other methods of forming the metal islands such as photolithography or electron beam lithography and etching may be used. In this case, said islands would preferably have diameters in the range 5 to 800 nm and be arranged in a regular array or in groups of regular arrays. Said islands may optionally be subjected to annealing after etching to reduce their diameters into the range 1 to 100 nm.

The catalyst metal is preferably Ni, but may be Fe or Co as known in the art. When Ni is used as a catalyst layer and the substrate is silicon, it is desirable and may be necessary to interpose a barrier layer between the silicon and the nickel to prevent the nickel diffusing into the silicon to form a silicide layer. Titanium (V I Merkulov, D H Lowndes, Y Y Wei et al) and silicon oxide have both been used for this purpose. Other conducting materials such as TiN, TaN, WN or other nitrides or metals such as Ti, W or Cr may be used.

Other methods of producing aligned carbon nanotubes known in the art may be used including microwave plasma enhanced chemical vapour deposition (Cui et al 88 2000), and the use of a porous substrate containing catalyst metal in the pores (Li et al).

During the growth of aligned carbon nanotubes by methods as described, the nanotubes grow perpendicular to the surface of the substrate, irrespective of substrate shape. They will therefore form a coating of upstanding nanotubes over a planar surface and will form a radially extending collar around a rod-like substrate. The shape of the cathode and the anode in a switch according to the invention may be freely chosen.

The anode or current collector of the switch may also comprise an array of aligned carbon nanotubes. The carbon nanotubes in the array on the anode may have any or all of the characteristics described above in relation to the cathode.

Electrical switch units may be constructed comprising a plurality of switches described herein connected in series or in parallel.

The invention will be further described and illustrated with reference to the accompanying drawings in which:
Figure 1 is a schematic diagram of a cold cathode vacuum switch; and
Figure 2 is a scanning electron microscope image of six nanotube arrays grown by plasma enhanced chemical vapour deposition on annealed Ni layers of differing thicknesses.

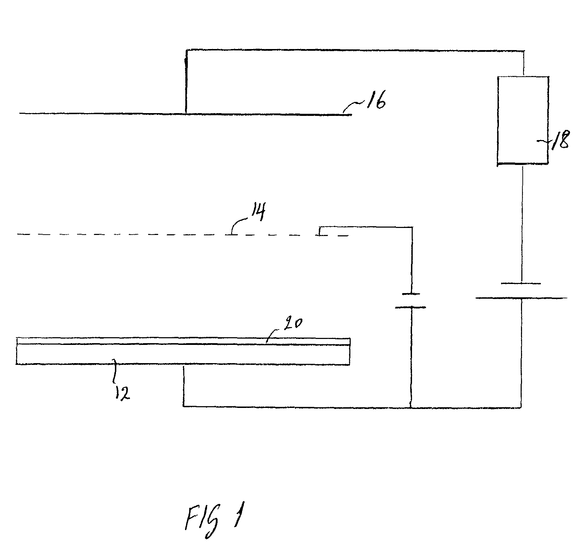

As shown in Figure 1, a cold cathode vacuum switch in its simplest form comprises a cathode 12 serving to emit electrons under the influence of voltage applied to a grid 14. Electrons emitted from the cathode 12 are accelerated past the grid 14 by a larger voltage applied between the cathode and an anode or electron collector 16. The current flowing through the switch is applied to a load 18.

In accordance with the invention, the face of the cathode facing the anode, and optionally the face of the anode facing the cathode, is provided with an array 20 of aligned carbon nanotubes serving as field emitters from which the electrons are emitted from the cathode and on which the electrons may be collected at the anode.

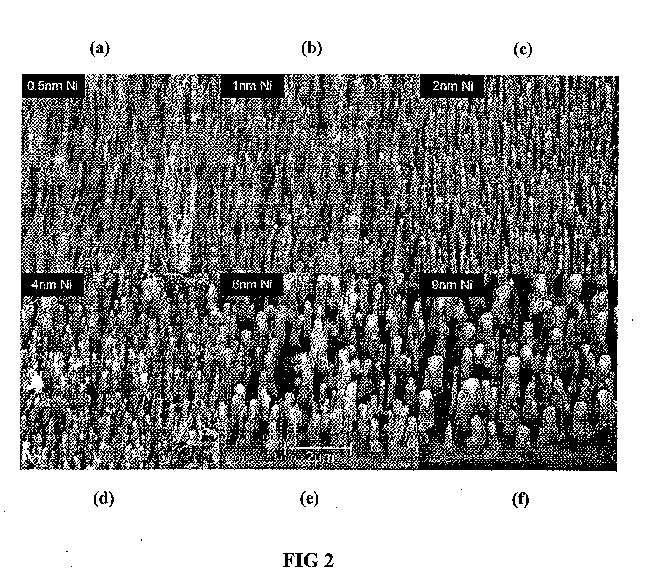

It is found that the effectiveness of an array of carbon nanotubes as electron emitters in such devices is dependent on the spacing between the tips of the nanotubes. If they are very closely spaced, as seen in Figure 2a-c, the tips electrically shield one another and reduce their effectiveness. Nanotubes which are further spaced from one another as in Figure 2d-f are more effective electron emitters, producing higher current densities. The more spaced nanotubes however are also typically shorter. If they are too short, the substrate on which they are grown (the back plane) may electrically interfere with the generation of a high field at the nanotube tips. Accordingly, it is preferred that the nanotubes should be at least 1 µm in height, e.g. from 1 to 10 µm.

### Example 1

A cathode or anode for a switch as described was produced as follows. A highly conductive graphite substrate was provided with a conductive surface layer of silicon oxide. A catalyst layer of desired thickness of Ni, suitably 4 nm was deposited by magnetron sputtering or thermal evaporation. The chamber was pumped down to a base pressure of 10⁻² Torr using a rotary pump. 20- 30 Torr of high purity hydrogen or nitrogen was then introduced via a leak valve. The Ni film was then annealed in vacuum at a temperature of 750 °C for 15 minutes to cause it to break up into islands. This is caused by surface tension and compressive stress due to the higher expansion coefficient of the Ni than the substrate. The diameter of the Ni islands is dependent on the initial Ni film thickness. The island diameter is much larger than the film thickness.

Aligned carbon nanotubes were now grown. The chamber was evacuated to base pressure and ammonia (NH₃) was introduced immediately.

The NH₃ flow was maintained by mass flow controllers at 200 sccm, achieving a pressure of 3.5 Torr.

A DC discharge between the cathode (sample) and the anode (2 mm diameter by 1 cm length copper wire) was initiated using an AE MDX 1kW supply. The anode-cathode distance was 2 cm. The bias voltage (Vb) was increased to -600V and the acetylene (C₂H₂) feed gas was introduced within a few seconds using a separate mass flow controller. The C₂H₂NH₃ flow ratio was chosen to be varied from 75% : 200 SCCM. The depositions were carried out for 15 minutes in a stable discharge.

Scanning electron microscope images of the carbon nanotube arrays produced on the cathodes or anodes are shown in Figure 2. The Ni thicknesses marked in each image relate to the thickness of the intial Ni film prior to annealing in each case.

Although the invention has been described with reference to preferred embodiments, many variations and modifications thereof are possible within the scope of the invention.

### References:

V I Merkulov, D H Lowndes, L R Baylor, Jnl App Phys, 89, No 3, 1 Feb 2000, 1933-1937
Z F Ren, Z P Huang, J W Xu, J H Wang, P Bush, M P Siegal and P N Provencio, Science 282 1105 (1998).
C Bower, O Zhou, W Zhu, D J Werder and S Jin, App Phys Lett 77 2767 2000.
V I Merkulov, D H Lowndes, Y Y Wei, G Eres and E Voelkl, App Phys Lett 76 3555 (2000).
R Andrews, D Jacques, A M Rao, F Derbyshire, D Qian, X Fan, E C Dickey and J Chen, Chem Phys Letts 303 467 (1999)
H Cui, O Zhou and B R Stoner, J App Phys 88 6072 (2000)
F Hoshi, K Tsugawa, A Goto, T Ishikura, S Yamashita, M Yumura, T Hirao, K oura, Y Koga, Diamond Related Mats, to be published (2001)
W A de Heer, A Chatelaine and D Ugarte, Science 270 1179 (1995)
J M Bonard, J P Salvetat, T Stockli , L Forro , A Chatelain, App Phys A 69 245 (1999)
J M Kim, W B Choi, N S Lee and J E Jung, Diamond Related Mats 9 1184 (2000)
W Zhu, C Bower, O Zhou, G Kochanski, S Jin, App Phys Lett 75 873 (1999).
P G Collins and A Zettl, App Phys Lett 69 1969 (1996)
W Z Li et al, Science 274, 1701 (1996)

## Claims

1. A vacuum power switch comprising a cathode, an anode and a current switching grid between the cathode and the anode, wherein the cathode comprises an array of aligned carbon nanotubes extending toward the anode.

2. A switch as claimed in claim 1, capable of switching a current of at least 5 amps at a voltage of 1 kV or more.

3. A switch as claimed in claim 2, capable of switching a current of at least 50 amps at a voltage of 1 kV or more.

4. A switch as claimed in claim 3, capable of switching a current of at least 500 amps at a voltage of 1 kV or more.

5. A switch as claimed in any preceding claim, wherein the nanotubes in said array have an average mid-length diameter of 5 nm or more.

6. A switch as claimed in claim 5, wherein the nanotubes in said array have an average mid-length diameter of from 5 to 100 nm.

7. A switch as claimed in any preceding claim, wherein the nanotubes in said array have an average spacing from the nearest neighbouring nanotube such as to produce a density of nanotubes on the surface of from 1 x 10⁴ to 1 x 10⁹/cm².

8. A switch as claimed in any preceding claim, wherein the nanotubes are produced by plasma enhanced chemical vapour deposition from a carbon containing gas onto a substrate bearing islands of catalytic metal.

9. A switch as claimed in claim 8, wherein said islands have an average diameter of from 5 to 100 nm.

10. A switch as claimed in claim 8 or claim 9, wherein said islands are formed by annealing a metal film deposited on a substrate so as to cause the film to break up to form said islands.

11. A switch as claimed in Claim 8 or Claim 9, wherein said islands are formed by photolithography or electron beam lithography and etching of a metal film deposited on a substrate.

12. A switch as claimed in claim 10, wherein the thickness of said film prior to annealing is at least 2 nm.

13. A switch as claimed in claim 12, wherein the thickness of said film prior to annealing is from 2 to 10 nm.

14. A switch as claimed in any preceding claim, wherein the anode also comprises an array of aligned carbon nanotubes.

15. An electrical switch unit comprising a plurality of switches as claimed in any one of claims 1 to 14 connected in series or in parallel.
